# EUROPEAN PATENT APPLICATION

(11) **EP 4 033 866 A1**
(43) Date of publication of application: **27.07.2022**
(21) Application number: 21197364.9
(22) Date of filing: 17.09.2021
(51) Int. Cl.: H05K 1/02

(54) **METALLIC REGIONS TO SHIELD A MAGNETIC FIELD SOURCE**

(30) Priority: 21.01.2021 US 202117154551
(71) Applicant: Intel Corporation, Santa Clara, CA 95054 (US)
(72) Inventor: Lee, Jaejin, Beaverton, 97007 (US); Lim, Min Suet, 11900 Penang (MY); Paniagua Acuna, Luis, 20108 Alajuela (CR); Chuah, Tin Poay, 11950 Bayan Baru (MY)
(74) Representative: Goddar, Heinz J.

(57) **Abstract**

Embodiments described herein may be related to apparatuses, processes, and techniques related to a shielding layer to be inserted under an inductor footprint to mitigate the impact of electromagnetic interference (EMI) onto electrical traces beneath the shielding layer and under the inductor footprint. In embodiments, the electrical traces may be high-speed input/output (HSIO) traces that may be particularly susceptible to data corruption given the level of EMI. In embodiments, the shielding layer may be a high density metallization shield within dielectric stack-up layers. In embodiments, these layers may use unique via patterns or shaped metal preform shields to enable routing under an inductor at a higher layer of the PCB. Other embodiments may be described and/or claimed.

## Description

### Field

Embodiments of the present disclosure generally relate to the field of printed circuit boards (PCBs), and in particular to providing electromagnetic shielding for electrical traces and components.

### Background

Continued growth in virtual machines and cloud computing will continue to increase the demand for increased performance and reduced size of computing devices by decreasing the size of a PCB of the computing device.

### Brief Description of the Drawings

FIGs. 1A-1C show examples of legacy techniques for routing signals underneath an inductor.
FIG. 2 shows a side view of one example of a stacked via array to allow electrical traces to run underneath an inductor, in accordance with various embodiments.
FIG. 3 shows a side view of another example of a stacked via array to allow electrical traces to run underneath an inductor, in accordance with various embodiments.
FIG. 4 shows top-down diagrams of examples of patterns of via arrays, in accordance with various embodiments.
FIG. 5 shows a side view and a perspective view of an example metal shield to allow electrical traces to run underneath an inductor, in accordance with various embodiments.
FIG. 6 shows a side view of another example metal shield to allow electrical traces to run underneath an inductor, in accordance with various embodiments.
FIGs. 7A-7E show a sequence of stages of manufacturing for creating a preformed metal shield within a PCB, in accordance with various embodiments.
FIG. 8 illustrates an example process for fabricating embedded metal shielding into a PCB, in accordance with various embodiments.
FIG. 9 illustrates an example computing device suitable for including various components of FIGs. 2-8, in accordance with various embodiments.

### Detailed Description

Embodiments described herein may be directed to a shielding layer to be inserted under an inductor footprint to mitigate the impact of electromagnetic interference (EMI) onto electrical traces beneath the shielding layer and under the inductor footprint. In embodiments, the electrical traces may be high-speed input/output (HSIO) traces that may be particularly susceptible to data corruption given the level of EMI. In embodiments, the electrical traces may include universal serial bus (USB) traces, peripheral component interconnect express (PCIe) traces, Thunderbolt (TBT) traces, and the like. In embodiments, the shielding layer may be a high density metallization shield within dielectric stack-up layers. In embodiments, these layers may use unique via patterns or shaped metal preform shields to enable routing under an inductor at a higher layer of the PCB.

In computing devices, for example in portable laptops or tablets, increased focus is placed on the length of battery life of the device. Expanding the size of the battery to achieve increased battery life may require a PCB reduction in XY area and width, for example through implementing a compact core of the PCB, or reducing the layers of the PCB. However, in legacy implementations these reductions may be constrained by platform routing rules that forbid any HSIO routing under a footprint of an inductor or other magnetic field generating device. For example, in legacy implementations, HSIO requires a fan out to avoid routing under the inductor, which yields a larger board width that reduces battery capacity.

For example, high current power delivery (PD) components may couple noise, up to hundreds of millivolts, onto nearby high-speed buses which may degrade or ruin bus margins and performance. In addition, an EMI field may be able to penetrate through micro-vias or plated through hole (PTH) voids to adjacent layers below the EMI source, particularly with respect to thin PCBs. In legacy implementations, transitioning a HSIO signal to the bottom of the PCB stack, which may be referred to as bottom layers of the PCB, to avoid routing directly under inductors may push a voltage regulator (VR) away from a system on chip (SOC) device, which reduces load line and performance, as well as core area.

In legacy implementations to overcome HSIO signal corruption, in addition to routing HSIO around the inductor or at the bottom PCB layer under the inductor, metal shield caps may be used to surround inductors. In embodiments, this may include metal enclosure that surrounds the shielded ferrite molded inductor. In addition, a bottom shield cap may be placed between the inductor and a top surface of the PCB. However, in these legacy implementations the overall height of the PCB plus the inductor may be increased due to the additional height required by the bottom shield and the shielding surrounding the inductor. In implementations, using a customized metal shield may add a Z height of around 200 µm to the top and bottom of the inductor, as well increase the dimensions of the XY area of the PCB. In addition, such shielding will increase the manufacturing cost. Also, this legacy implementation may require a more expensive PCB stack up, for example using via any layer (VAL) to allow HSIO routing at bottom PCB layers. In addition, the quality factor and inductance of the shielded inductor may be degraded by the metal enclosure causing eddy current impact.

In embodiments, the thicker dielectric layer thickness at the top layer of the PCB may be used to insert a metallic shielding layer to be inserted under an inductor footprint. In embodiments, the shielding layer may occupy the full dielectric layer thickness. In embodiments, multiple dielectric layers may be used. In embodiments, the shielding may be provided by a micro via a pattern (array), or a metal shield, that may be pre-formed, and applied to the PCB during buildup. These embodiments may result in the ability to miniaturize the platform and provide longer battery life by enabling a narrow board width eliminating the need for HSIO to fan out to avoid routing under the inductor. In addition, these embodiments may result in better power delivery due to a shorter power delivery path, reducing the distance from the VR to the SOC.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

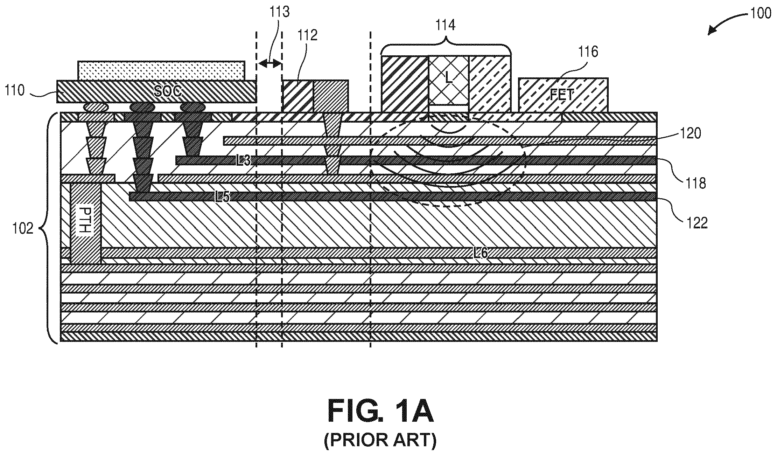

FIGs. 1A-1C show examples of legacy techniques for routing signals underneath an inductor. FIG. 1A shows legacy device 100 includes PCB 102 to which an SOC 110, a VR 112, an inductor 114, and a field effect transformer (FET) 116 are physically and electrically coupled. The VR is separated from the SOC by distance 113. As shown, the inductor 114, during operation, may generate an EMI field 120 that extends into the PCB 102. In implementations, trace 118 on layer L3 of PCB 102, and trace 122 on L5 of PCB 102, may be electrically coupled with the SOC 110 and routed underneath the inductor 114, thus encountering at least a part of the EMI field 120. In embodiments, traces 118, 122 may be HSIO traces. As a result, legacy device 100, during operation, may see data corruption or signal instability on traces 118, 122 due to their interaction with EMI field 120.

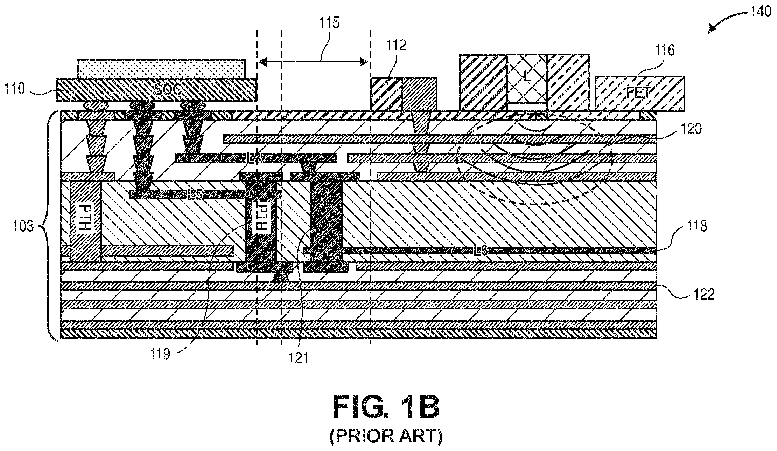

FIG. 1B shows legacy device 140 that includes PCB 103, which may be similar to PCB 102, to which an SOC 110, a VR 112, an inductor 114, and FET 116 are physically and electrically coupled. However, unlike legacy device 100, legacy device 140 has a trace 118 routed on PCB 103 layer L6 and trace 122 routed on PCB 103 layer L8. Although traces 118, 122 are clear from EMI field 120, this comes as a result of increasing the distance between SOC 110 and VR 112 to a distance 115. This additional distance 115 is required due to additional PTH 119, 121 to be built inside the PCB 103 in order to route the traces 118, 120 back up to the SOC 110. Thus, the XY dimension of legacy device 140 is larger than the corresponding XY dimension of legacy device 100.

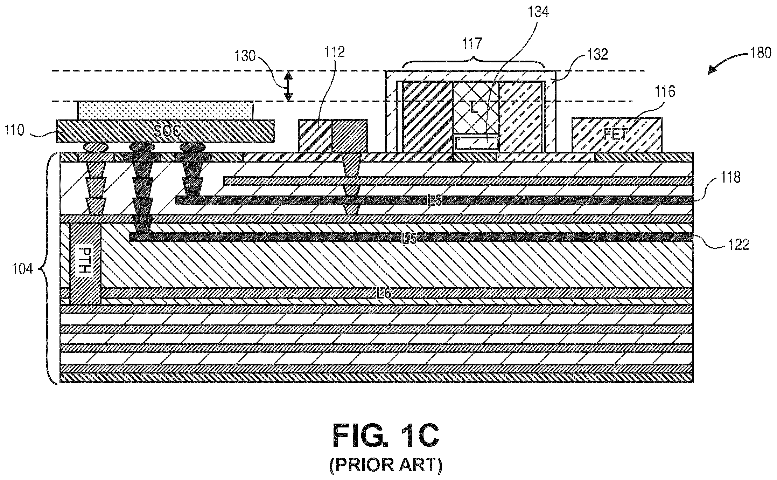

FIG. 1C shows legacy device 180 that includes PCB 104, which may be similar to PCB 102, to which an SOC 110, a VR 112, an inductor 117, which may be similar to inductor 114 of legacy device 100, and FET 116 are physically and electrically coupled. Similar to PCB 102, a trace 118 is on layer L3 and a trace 122 is on L5, both electrically coupled with SOC 110. However, unlike legacy device 100, legacy device 180 has a metal shielding 132 that surrounds inductor 117, and a metal shield 134 below the inductor 117. Although this legacy implementation provide shielding for traces 118, 122, this implementation also increases the height of the components above the PCB 104, in comparison to legacy device 100, by a distance 130. Thus, in this implementation the distance 130 represents a decrease in the volume otherwise available for a battery or other components to fit with legacy device 180 into an end-user computing device (not shown).

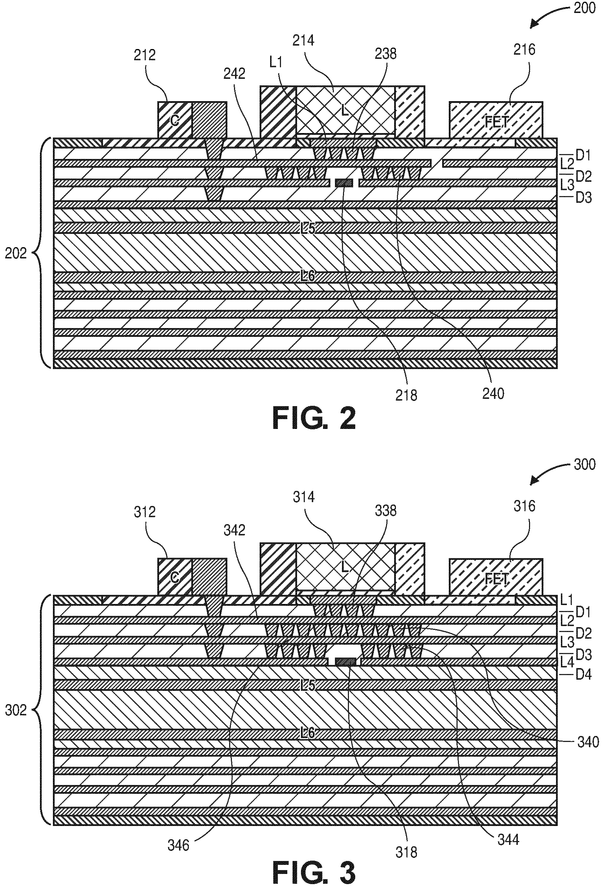

FIG. 2 shows a side view of one example of a stacked via array to allow electrical traces to run underneath an inductor, in accordance with various embodiments. Device 200, which may have some similarities with legacy device 100, may include a PCB 202 with a VR 212, an inductor 214, and FET 216 are physically and electrically coupled with the PCB 202. In embodiments, a first via array 238 may be disposed underneath inductor 214 to provide partial EMI field shielding when inductor 214 is in operation. In embodiments, the first via array 238 may be coupled with a portion of conducting layer L1. In embodiments, conducting layer L1 may be used to physically and electrically couple individual vias of the via array 238, and to provide additional EMI field protection beneath the inductor 214.

In embodiments, a second via array 240 may be electrically and physically coupled to the first via array 238 by a conductive layer 242. In embodiments, the conductive layer 242 may be a part of layer L2 of PCB 202. Note that in embodiments an area of the second via array 240 may overlap the area of the first via array 238, and may provide a "hat"-shaped shielding for trace 218. In embodiments, a shape of the first via array 238 and the second via array 240 may be determined based on the footprint of inductor 214, as well as other EMI field-inducing devices or routings on or within the PCB 202. In embodiments, the inductor 214 may be oriented perpendicular to the trace 218 routing path. In embodiments, the trace 218 may be one or more HSIO.

In embodiments, first via array 230 or the second via array 240 may be constructed of micro vias. In embodiments, the first via array 230 or the second via array 240 may be fabricated using a laser drill process, and may be arranged in a staggered or in-line pattern as discussed further below. In embodiments, the first via array 230 or the second via array 240 may be filled with copper or some other conductive metal, and may be electrically coupled with a PCB ground layer (not shown). In embodiments, a gap within the second via array 240 may exist to allow the trace 218 to route within the second via array 240, for example within layer L3 of PCB 202, and below the first via array 238. In embodiments, there may be multiple gaps within the second via array 242 allow for multiple traces 218 to route underneath the inductor 214. In other embodiments, the trace 218 may be routed below the second via array 240.

FIG. 3 shows a side view of another example of a stacked via array to allow electrical traces to run underneath an inductor, in accordance with various embodiments. Device 300, which may be similar to device 200, may include a PCB 302 with a VR 312, an inductor 314, and FET 316 physically and electrically coupled with the PCB 302, which may be similar to PCB 202, VR 212, inductor 214, and FET 216 of FIG. 2. In embodiments, a first via array 338, which may be similar to first via array 238, may be disposed underneath inductor 314 to provide partial EMI field shielding when inductor 314 is in operation. In embodiments, the first via array 338 may be coupled with a portion of conducting layer L1. In embodiments, conducting layer L1 may be used to physically and electrically couple individual vias of the via array 338, and to provide additional EMI field protection beneath the inductor 314.

In embodiments, a second via array 340 may be electrically and physically coupled to the first via array 338 by a conductive layer 342. In embodiments, the conductive layer 342 may be a part of layer L2 of PCB 302. Furthermore, in embodiments a third via array 344 may be electrically and physically coupled to the second via array of 340 by conductive layer 346. In embodiments, the conductive layer 346, may be a part of layer L3 of PCB 302. In embodiments, a shape of the third via array 344 may be similar to the first via array 338 or the second via array 340. The dimension or geometry of the via arrays 338, 340, 344 may be determined based on the footprint of inductor 314, as well as other EMI field-inducing devices or routings on or within the PCB 302.

In embodiments, the trace 318, which may be similar to trace 218 of FIG. 2, may be one or more HSIO. In addition, via arrays 338, 340, 346 may be implemented on other layers of the PCB 302 depending upon the shielding thickness required or shielding that may or may not be present in other layers of the PCB 302.

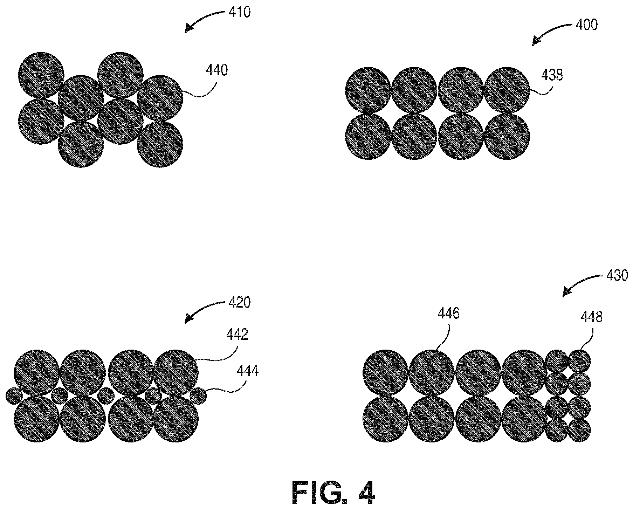

FIG. 4 shows top-down diagrams of examples of patterns of via arrays, in accordance with various embodiments. Partial pattern 400 shows a pattern of via arrays that are in an in-line formation, which may be similar to first via array 338, second via array 340, or third via array 344 of FIG. 3. As shown, each of the vias 438 are within rows and columns. In embodiments, each via 438 may be tangent with or proximately tangent with four other vias 438.

Partial pattern 410 shows a pattern of via arrays that are in a staggered formation, which may be similar to first via array 338, second via array 340, or third via array 344 of FIG. 3. As shown, each of the vias 440 may be disposed along diagonals and vertical columns. In embodiments, each via 440 may be tangent with her proximately tangent with six other vias 440. The partial pattern 410 may achieve a denser via array with less white space between each via.

Partial pattern 420 shows a pattern of via arrays of multiple sizes that are interlaced, which may be similar to first via array 338, second via array 340, or third via array 344 of FIG. 3. As shown, vias 442, which may be similar to vias 438, may have other vias 444 of different size that are interlaced within the larger vias 442. In embodiments, this may simplify manufacturing while providing a larger metal layer density as compared with partial pattern 400 above. In embodiments, multiple, various sizes of vias 442, 444 may be used in variations of partial pattern 420.

Partial pattern 430 shows a pattern of via arrays of multiple sizes that are not interlaced, which may be similar to first via array 338, second via array 340, or third via array 344 of FIG. 3. As shown, vias 446 may be of a first size, and vias 448 may be of a second size. In embodiments, the positioning of the vias 446, 448 may be due to varying EMI field shielding requirements within arrays 338, 340, 344 of FIG. 3. In embodiments, the positioning of vias 446, 448 may also be used to facilitate trace routing through the arrays. In embodiments, the vias 438, 440, 442, 444, 446, 448 may be formed within the PCB 302 build up through drilling. In embodiments, the vias may be filled with copper or some other metal depending upon the shielding requirements for the traces such as trace 318 running underneath inductor 314 of FIG. 3.

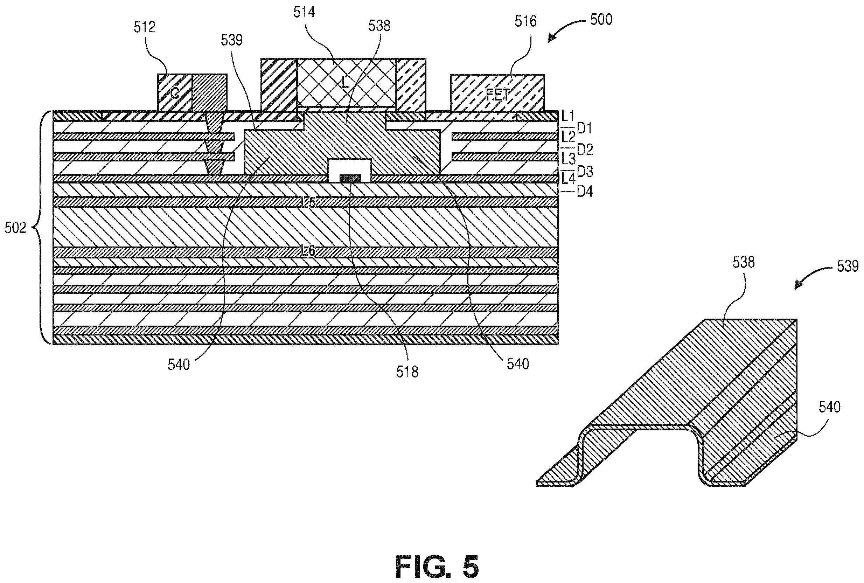

FIG. 5 shows a side view and a perspective view of an example metal shield to allow electrical traces to run underneath an inductor, in accordance with various embodiments. Device 500, which may be similar to device 300, may include a PCB 502 with a VR 512, an inductor 514, and FET 516 physically and electrically coupled with the PCB 502, which may be similar to PCB 302, VR 312, inductor 314, and FET 316 of FIG. 3.

A metal shield block 539 may be electrically and physically coupled with a portion of conducting layer L1. In embodiments, a upper portion 538 of the metal shield block 539 may be disposed underneath the inductor 514 to shield EMI generated while the inductor 514 is in operation. The lower portion 540 of the metal shield block 539 may be electrically and physically coupled with the upper portion 538 to provide EMI field shielding to trace 518, which may be similar to trace 318 of FIG. 3.

In embodiments, the upper portion 538 and the lower portion 540 of the metal shield block 539 may be a unibody construction. In embodiments, the metal shield block 539 may be made of copper, aluminum, gold-plated material, or another metal or alloy that facilitates EMI field shielding. In embodiments, the upper portion 538 may be present in one or more conductive layers, for example L1 of the PCB 502, and/or one or more dielectric layers, for example dielectric layer D1, of the PCB 502.

Metal shield 539, as shown in diagram 539, is a perspective view of metal shield 539, with upper portion 538 physically and electrically coupled with lower portion 540, as a unibody construction.

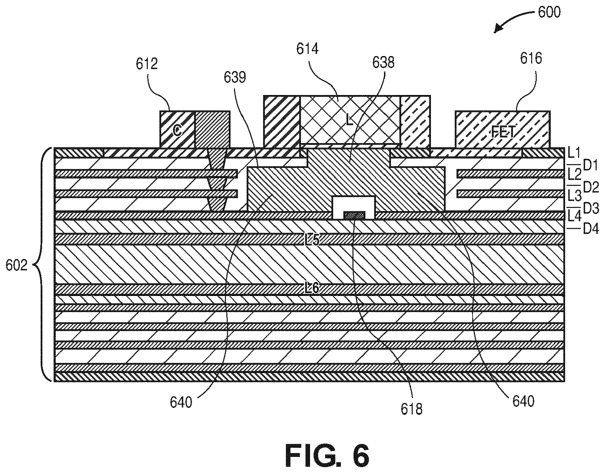

FIG. 6 shows a side view of another example metal shield to allow electrical traces to run underneath an inductor, in accordance with various embodiments. Device 600, which may be similar to device 500 of FIG. 5, may include a PCB 602 with a VR 612, an inductor 614, and FET 616 physically and electrically coupled with the PCB 602, which may be similar to PCB 502, VR 512, inductor 514, and FET 516 of FIG. 5.

In embodiments, a metal shield block 639, which may be similar to metal shield block 539 of FIG. 5, may be disposed underneath inductor 614 to provide partial EMI field shielding when inductor 614 is in operation. In embodiments, the upper portion 638 of the metal shield block 639 may be electrically and physically coupled with the lower portion 640, which may be similar to lower portion 540 of FIG. 5. In embodiments, the metal shield block 639 may be electrically coupled with a ground, such as a ground trace in L4. In embodiments, the upper portion 538 and the lower portion 540 may be referred to as a "hat shape" shield.

The lower portion 640 of the metal shield block 639 may be electrically and physically coupled with the upper portion 638 to provide EMI field shielding to trace 618, which may be similar to trace 518 of FIG. 5. In embodiments, the upper portion 638 and the lower portion 640 of the metal shield block 639 may be a unibody construction. In embodiments, the metal shield block 639 may be made of copper, aluminum, gold plated material, or another metal or alloy that facilitates EMI field shielding. In embodiments, the upper portion 638 may be present in one or more conductive layers, for example L1 of the PCB 602, and/or one or more dielectric layers, for example dielectric layers D2 and D3, of the PCB 602. As shown here, the lower portion 640 extends through multiple dielectric layers.

In embodiments, the trace 618, which may be similar to trace 518 of FIG. 5, may be one or more HSIO. In addition, the metal shield block 639 may be implemented on other layers of the PCB 602 depending upon the shielding thickness required or shielding that may or may not be present in other layers of the PCB 602.

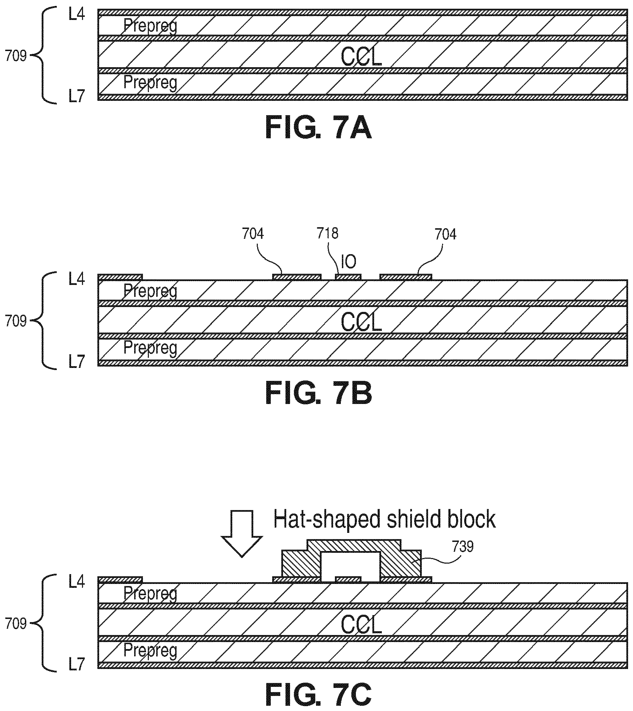

FIGs. 7A-7E show a sequence of stages of manufacturing for creating a preformed metal shield within a PCB, in accordance with various embodiments. FIG. 7A shows a PCB core 709, of a PCB which may be similar to PCB 602 of FIG. 6. In embodiments, the top layer L4 in the bottom layer L7 may include copper layers. FIG. 7B shows that a portion of has been etched to produce landing pads 709 for metal shield 539, 639 as well as trace 718, which may be similar to trace 518, 618 of FIGs. 5-6. FIG. 7C shows the application of the metal shield 739, which may be similar to metal shields 539, 639, physically and electrically coupled to the landing pads 709. In embodiments, the metal shield 739 may be pre-formed and attached as a unibody structure. In embodiments, this may be referred to as "pick and place." In embodiments, the landing pads 709 may be electrically coupled with an electrical ground. In embodiments, a conductive adhesive (not shown) may be placed on the landing pads 709 or at the bottom of the metal shield 739 to keep the metal shield 739 in place once it is positioned.

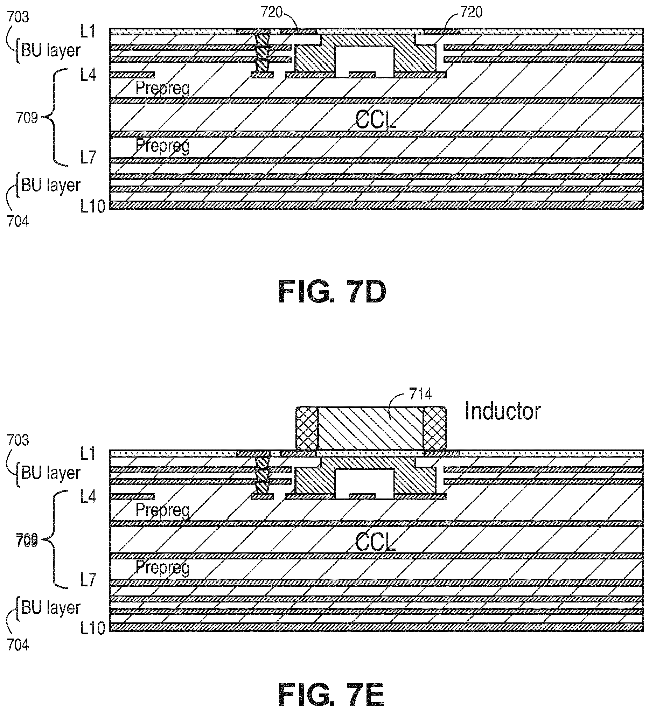

FIG. 7D shows a buildup layer 703, 704 on either side of core 709, and encompassing the metal shield 739. FIG. 7E shows an inductor 714 electrically and physically coupled to the first buildup layer 703. In embodiments, the inductor 714 may be coupled to inductor pads 720 to electrically couple the inductor 714 to the buildup layer 703. In embodiments, the first buildup layer 703, which also may be referred to as a prepreg layer, may need to be precut prior to placing the metal shield 739.

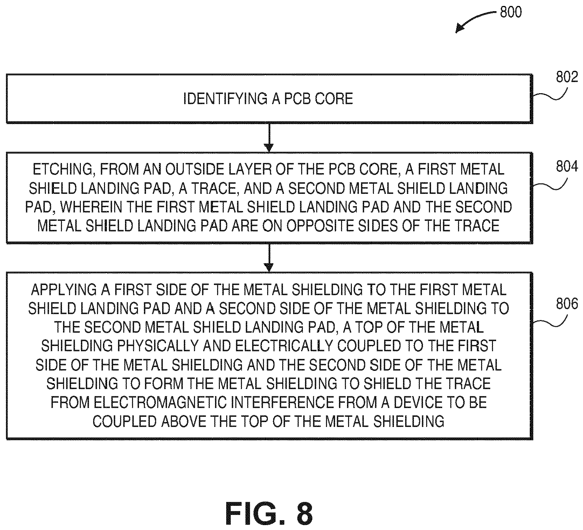

FIG. 8 illustrates an example process for fabricating embedded metal shielding into a PCB, in accordance with various embodiments. Process 800 may be implemented using the apparatus, techniques, processes, or systems described herein and in particular with respect to FIGs. 5-7E.

At block 802, the process may include identifying a PCB core. In embodiments, the PCB core may be similar to PCB be core 709 of FIGs. 7A-7E. In embodiments, the PCB core may be a copper clad laminate (CCL).

At block 804, the process may further include etching, from an outside layer of the PCB core, a first metal shield landing pad, a trace, and a second metal shield landing pad, wherein the first metal shield landing pad and the second metal shield landing pad are on opposite sides of the trace. In embodiments, the first metal shielding landing pad and second metal shielding landing pad may be similar to landing pads 704, and the trace may be similar to trace 718 of FIG. 7B.

At block 806, the process may further include applying a first side of the metal shielding to the first metal shield landing pad and a second side of the metal shielding to the second metal shield landing pad, a top of the metal shielding physically and electrically coupled to the first side of the metal shielding and the second side of the metal shielding to form the metal shielding to shield the trace from electromagnetic interference from a device to be coupled above the top of the metal shielding. In embodiments, the melted shielding may be similar to metal shielding 539 of FIG. 5 or 639 of FIG. 6. In embodiments, the metal shielding may be a unibody shield that has been previously manufactured.

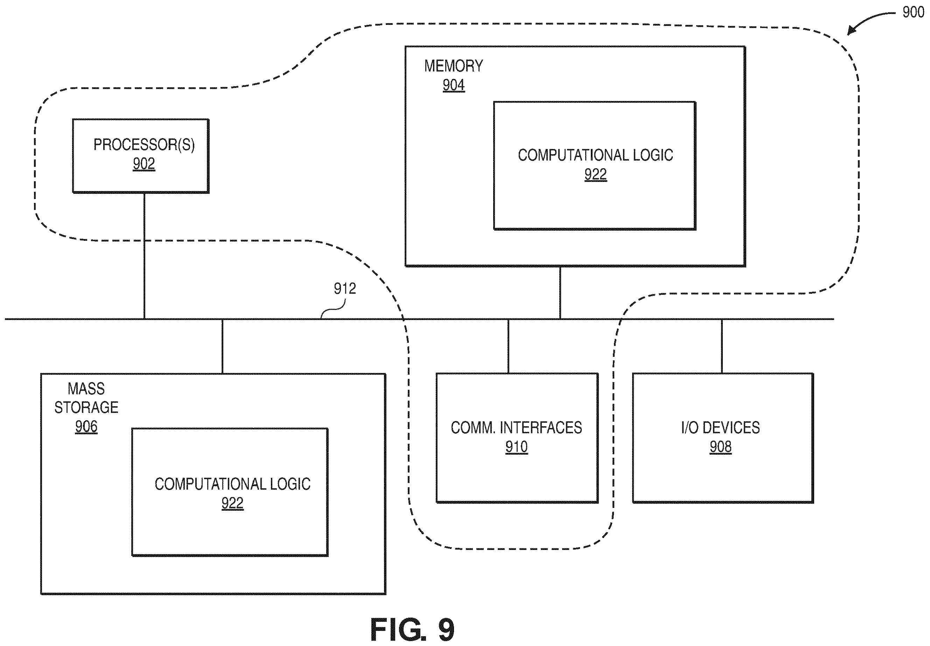

FIG. 9 illustrates an example computing device suitable for including various components of FIGs. 2-8, in accordance with various embodiments. As shown, computing device 900 may include one or more processors or processor cores 902, system memory 904, mass storage 906, communication interfaces 910 and I/O devices 908, coupled with each other via one or more buses/interconnects 912. In various embodiments, at least one of the buses/interconnects 912 is an optical bus/interconnect optically coupling/interconnecting at least two of processors 902, system memory 904, mass storage 906, communication interfaces 910 and I/O devices 908. That is, the at least two of processors 902, system memory 904, mass storage 906, communication interfaces 910 and I/O devices 908 being optically coupled include coherent optical transceiver . In various embodiments, processor(s) 902 and at least one of memory 904 and communication interfaces 910 are incorporated with the magnetic shielding technology of the present disclosure, as earlier described with references to FIGs 2-8.

For the purpose of this application, including the claims, the terms "processor" and "processor cores" may be considered synonymous, unless the context clearly requires otherwise. The processor 902 may include any type of processors, a microprocessor, and the like. The processor 902 may be implemented as an integrated circuit having multi-cores, e.g., a multicore microprocessor.

Mass storage devices 906 may be one of diskette, hard drive, volatile memory (e.g., dynamic random-access memory (DRAM), compact disc read-only memory (CD-ROM), digital versatile disk (DVD), and so forth. In general, system memory 904 and/or mass storage devices 906 may be temporal and/or persistent storage of any type, including, but not limited to, volatile and non-volatile memory, optical, magnetic, and/or solid state mass storage, and so forth. Volatile memory may include, but is not limited to, static and/or dynamic random access memory. Non-volatile memory may include, but is not limited to, electrically erasable programmable read-only memory, phase change memory, resistive memory, and so forth.

I/O devices 908 may be a display (e.g., a touchscreen display)), keyboard, cursor control, remote control, gaming controller, image capture device, a camera, one or more sensors, and so forth and communication interfaces 910 may include network interface cards, serial buses, modems, infrared receivers, radio receivers (e.g., Bluetooth), and so forth).

The communication interfaces 910 may include communication chips (not shown) that may be configured to operate the device 900 in accordance with a Global System for Mobile Communication (GSM), General Packet Radio Service (GPRS), Universal Mobile Telecommunications System (UMTS), High Speed Packet Access (HSPA), Evolved HSPA (E-HSPA), or Long-Term Evolution (LTE) network. The communication chips may also be configured to operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chips may be configured to operate in accordance with Code Division Multiple Access (CDMA), Time Division Multiple Access (TDMA), Digital Enhanced Cordless Telecommunications (DECT), Evolution-Data Optimized (EV-DO), derivatives thereof, as well as any other wireless protocols that are designated as 3G, 4G, 5G, and beyond.

System buses/Interconnects 912 may include, for example, PCIe buses. In other words, selected ones of processors 902, memory 904, mass storage 906, communication interfaces 910 and I/O devices 908 may be PCIe devices or other serial bus-based devices. In particular, they may be PCIe devices incorporated with the teachings of the present disclosure of coupled metallic regions to shield a magnetic field source. In the case of multiple buses, they may be bridged by one or more bus bridges (not shown).

Each of these elements may perform its conventional functions known in the art. In particular, system memory 904 and mass storage devices 906 may be employed to store a working copy and a permanent copy of the programming instructions for the operation of various components of computing device 900, including but not limited to an operating system of computing device 900, one or more applications, and/or system software/firmware in support of practice of the present disclosure, collectively referred to as computing logic 922. The various elements may be implemented by assembler instructions supported by processor(s) 902 or high-level languages that may be compiled into such instructions.

The permanent copy of the programming instructions may be placed into mass storage devices 906 in the factory, or in the field through, for example, a distribution medium (not shown), such as a compact disc (CD), or through communication interface 910 (from a distribution server (not shown)). That is, one or more distribution media having an implementation of the agent program may be employed to distribute the agent and to program various computing devices.

The number, capability, and/or capacity of the elements 902, 904, 906, 908, 910, and 912 may vary, depending on whether computing device 900 is used as a stationary computing device, such as a set-top box or desktop computer, or a mobile computing device, such as a tablet computing device, laptop computer, game console, or smartphone. Their constitutions are otherwise known, and accordingly will not be further described.

In embodiments, at least one of processors 902 may be packaged together with computational logic 922 configured to practice aspects of embodiments described herein to form a System in Package (SiP) or a System on Chip (SOC).

In various implementations, the computing device 900 may be one or more components of a data center, a laptop, a netbook, a notebook, an ultrabook, a smartphone, a tablet, a personal digital assistant (PDA), an ultra mobile PC, a mobile phone, a digital camera, or an IoT user equipment. In further implementations, the computing device 900 may be any other electronic device that processes data.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments.

### EXAMPLES

Example 1 is a printed circuit board (PCB) apparatus comprising: a first side and a second side opposite the first side; a first metallic region within a first layer proximate to the first side, the first metallic region overlaps a location on the first side where a device to generate a magnetic field is to be disposed; a second metallic region within a second layer underneath the first layer, the second metallic region coupled with the first metallic region, and a perimeter of the second metallic region overlaps at least a portion of a perimeter of the first metallic region; and wherein the first metallic region and the second metallic region are to provide magnetic shielding for electrical traces routed underneath the location on the first side of the PCB.
Example 2 may include the apparatus of example 1, wherein the second metallic region includes one or more electrical traces not electrically coupled with the second metallic region to route underneath the location.
Example 3 may include the apparatus of example 1, further comprising a third metallic region within a third layer disposed between the first layer and the second layer, the third metallic region electrically coupled with the second metallic region.
Example 4 may include the apparatus of example 1, wherein the first metallic region is a metal layer.
Example 5 may include the apparatus of example 4, wherein the first metallic region and the second metallic region are a solid metal.
Example 6 may include the apparatus of example 1, wherein the first metallic region or the second metallic region include a plurality of vias filled with a metal.
Example 7 may include the apparatus of example 6, wherein one or more of the plurality of vias are arranged by a selected one of: adjacent to 4 other vias, or adjacent to 6 other vias.
Example 8 may include the apparatus of example 6, wherein the vias are filled with one or more of: copper, nickel, gold, tin, or aluminum.
Example 9 may include the apparatus of example 6, wherein two or more of plurality of vias are different diameters.
Example 10 may include the apparatus of example 1, wherein the first layer or the second layer is a dielectric layer.
Example 11 may include the apparatus of example 10, wherein the first layer and the second layer have different thicknesses.
Example 12 may include the apparatus of example 1, wherein the second layer includes multiple sublayers.
Example 13 may include the apparatus of any one of examples 1-12, wherein the device to generate the magnetic field is a selected one of: an inductor or a field effect transformer (FET).
Example 14 is a method for fabricating embedded metal shielding into a printed circuit board (PCB), the method comprising: identifying a PCB core; etching, from an outside layer of the PCB core, a first metal shield landing pad, a trace, and a second metal shield landing pad, wherein the first metal shield landing pad and the second metal shield landing pad are on opposite sides of the trace; and applying a first side of the metal shielding to the first metal shield landing pad and a second side of the metal shielding to the second metal shield landing pad, a top of the metal shielding physically and electrically coupled to the first side of the metal shielding and the second side of the metal shielding to form the metal shielding to shield the trace from electromagnetic interference from a device to be coupled above the top of the metal shielding.
Example 15 may include the method of example 14, further comprising: applying buildup layers to the outside layer of the PCB core and around the metal shielding.
Example 16 may include the method of example 15, further comprising: physically and electrically coupling the device to the PCB at a location above the metal shielding.
Example 17 may include the method of any one of examples 14-16, wherein the first and the second metal shield landing pad, the first and second side of the metal shielding, and the top of the metal shielding include copper.
Example 18 is a system comprising: a printed circuit board (PCB) apparatus comprising: a first side and a second side opposite the first side; a first metallic region within a first layer proximate to the first side, the first metallic region overlaps a location on the first side where a device to generate a magnetic field is to be disposed; a second metallic region within a second layer underneath the first layer, the second metallic region electrically coupled with the first metallic region, and a perimeter of the second metallic region overlaps at least a portion of a perimeter of the first metallic region; and wherein the first metallic region and the second metallic region are arranged to provide magnetic shielding for electrical traces routed underneath the location on the first side of the PCB; and the device electrically and physically coupled with the PCB and disposed at the location of the first side.
Example 19 may include the system of example 18, wherein the first metallic region or the second metallic region includes a plurality of vias filled with a metal, and wherein one or more of the plurality of vias are arranged by a selected one of: adjacent to 4 other vias, or adjacent to 6 other vias.
Example 20 may include the system of example 19, wherein the plurality of vias are filled with copper.

## Claims

1. A printed circuit board (PCB) apparatus comprising:
a first side and a second side opposite the first side;
a first metallic region within a first layer proximate to the first side, the first metallic region overlaps a location on the first side where a device to generate a magnetic field is to be disposed;
a second metallic region within a second layer underneath the first layer, the second metallic region coupled with the first metallic region, and a perimeter of the second metallic region overlaps at least a portion of a perimeter of the first metallic region; and
wherein the first metallic region and the second metallic region are to provide magnetic shielding for electrical traces routed underneath the location on the first side of the PCB.

2. The apparatus of claim 1, wherein the second metallic region includes one or more electrical traces not electrically coupled with the second metallic region to route underneath the location.

3. The apparatus of claim 1, further comprising a third metallic region within a third layer disposed between the first layer and the second layer, the third metallic region electrically coupled with the second metallic region.

4. The apparatus of claim 1, wherein the first metallic region is a metal layer, or wherein the first metallic region and the second metallic region are a solid metal.

5. The apparatus of claim 1, wherein the first metallic region or the second metallic region include a plurality of vias filled with a metal; and wherein one or more of the plurality of vias are arranged by a selected one of: adjacent to 4 other vias, or adjacent to 6 other vias.

6. The apparatus of claim 5, wherein the vias are filled with one or more of: copper, nickel, gold, tin, or aluminum.

7. The apparatus of claim 1, wherein the first layer or the second layer is a dielectric layer; and wherein the first layer and the second layer have different thicknesses.

8. A method for fabricating embedded metal shielding into a printed circuit board (PCB), the method comprising:
identifying a PCB core;
etching, from an outside layer of the PCB core, a first metal shield landing pad, a trace, and a second metal shield landing pad, wherein the first metal shield landing pad and the second metal shield landing pad are on opposite sides of the trace; and
applying a first side of the metal shielding to the first metal shield landing pad and a second side of the metal shielding to the second metal shield landing pad, a top of the metal shielding physically and electrically coupled to the first side of the metal shielding and the second side of the metal shielding to form the metal shielding to shield the trace from electromagnetic interference from a device to be coupled above the top of the metal shielding.

9. The method of claim 8, further comprising:
applying buildup layers to the outside layer of the PCB core and around the metal shielding; and
physically and electrically coupling the device to the PCB at a location above the metal shielding.

10. The method of any one of claims 8-9, wherein the first and the second metal shield landing pad, the first and second side of the metal shielding, and the top of the metal shielding include copper.

11. A system comprising:
a printed circuit board (PCB) apparatus comprising:
a first side and a second side opposite the first side;
a first metallic region within a first layer proximate to the first side, the first metallic region overlaps a location on the first side where a device to generate a magnetic field is to be disposed;
a second metallic region within a second layer underneath the first layer, the second metallic region electrically coupled with the first metallic region, and a perimeter of the second metallic region overlaps at least a portion of a perimeter of the first metallic region; and
wherein the first metallic region and the second metallic region are arranged to provide magnetic shielding for electrical traces routed underneath the location on the first side of the PCB; and
the device electrically and physically coupled with the PCB and disposed at the location of the first side.

12. The system of claim 11, wherein the device is a selected one of: an inductor or a field effect transformer (FET).

13. An apparatus, comprising:
means for identifying a PCB core;
means for etching, from an outside layer of the PCB core, a first metal shield landing pad, a trace, and a second metal shield landing pad, wherein the first metal shield landing pad and the second metal shield landing pad are on opposite sides of the trace; and
means for applying a first side of the metal shielding to the first metal shield landing pad and a second side of the metal shielding to the second metal shield landing pad, a top of the metal shielding physically and electrically coupled to the first side of the metal shielding and the second side of the metal shielding to form the metal shielding to shield the trace from electromagnetic interference from a device to be coupled above the top of the metal shielding.

14. The apparatus of claim 13, further comprising:
means for applying buildup layers to the outside layer of the PCB core and around the metal shielding.

15. The apparatus of claim 14, further comprising: means for physically and electrically coupling the device to the PCB at a location above the metal shielding.
